(19) Europäisches Patentamt
European Patent Office
Office européen des brevets

(11) **EP 3 432 009 B1**

(12) **FASCICULE DE BREVET EUROPEEN**

(45) Date de publication et mention
de la délivrance du brevet:
**21.09.2022 Bulletin 2022/38**

(21) Numéro de dépôt: **18184373.1**

(22) Date de dépôt: **19.07.2018**

(51) Classification Internationale des Brevets (IPC):
*G01R 29/08* (2006.01)    *G01R 29/10* (2006.01)
*H01Q 3/26* (2006.01)    *H01Q 13/08* (2006.01)
*H04B 17/16* (2015.01)

(52) Classification Coopérative des Brevets (CPC):
**G01R 29/10; G01R 29/0878; H01Q 3/267;
H01Q 13/08; H04B 17/16**

(54) **DISPOSITIF DE STIMULATION D'ANTENNES EN CHAMP PROCHE**

VORRICHTUNG ZUR STIMULATION VON NAHFELD-ANTENNEN

DEVICE FOR STIMULATING NEAR-FIELD ANTENNAS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.07.2017 FR 1700775**

(43) Date de publication de la demande:
**23.01.2019 Bulletin 2019/04**

(73) Titulaire: **THALES**
**92400 Courbevoie (FR)**

(72) Inventeurs:
- **MAZEAU, Thierry**
**33700 Merignac (FR)**
- **BOULANGEY, Jean-Marie**
**78851 Elancourt (FR)**
- **PERPERE, Bernard**
**78851 Elancourt (FR)**
- **JAHAN, Daniel**
**29238 Brest Cedex 3 (FR)**

(74) Mandataire: **Atout PI Laplace**
**Immeuble "Visium"**
**22, avenue Aristide Briand**
**94117 Arcueil Cedex (FR)**

(56) Documents cités:
**CN-A- 102 735 950**    **DE-A1-102016 001 370**
**JP-A- 2009 058 384**    **US-A1- 2002 095 304**
**US-A1- 2007 013 607**    **US-A1- 2011 077 509**
**US-B1- 6 215 448**

- **DAISUKE UCHIDA ET AL: "Novel high-spatial
resolution probe for electric near-field
measurement", RADIO AND WIRELESS
SYMPOSIUM (RWS), 2011 IEEE, IEEE, 16 janvier
2011 (2011-01-16), pages 299-302, XP031930418,
DOI: 10.1109/RWS.2011.5725457 ISBN:
978-1-4244-7687-9**

**Description**

*DOMAINE DE L'INVENTION*

L'invention se rapporte au domaine général des systèmes de réception de signaux radioélectriques et notamment aux systèmes comportant plusieurs antennes fixes tels que, par exemple, des détecteurs de radars ou des intercepteurs de communications comportant plusieurs antennes de réception.

Elle concerne plus particulièrement les systèmes de test en champ proche permettant de stimuler un système de réception par des signaux représentatifs sans intervenir dans le matériel à des fins de tests ou d'entraînement.

*CONTEXTE DE L'INVENTION - ART ANTERIEUR*

Les systèmes de réception de signaux radioélectriques actuels utilisent généralement des ensembles constitués de plusieurs antennes réparties dans un espace donné ou sur une surface donnée.

Ces systèmes de réception de signaux radioélectriques, une fois installés sur leur plate-forme porteuse, font l'objet de tests de vérification de bon fonctionnement en fin d'installation, puis en maintenance, mais peuvent également faire l'objet de tests d'investigation pour parfaire la connaissance de leur comportement radioélectrique ou comprendre un comportement anormal.

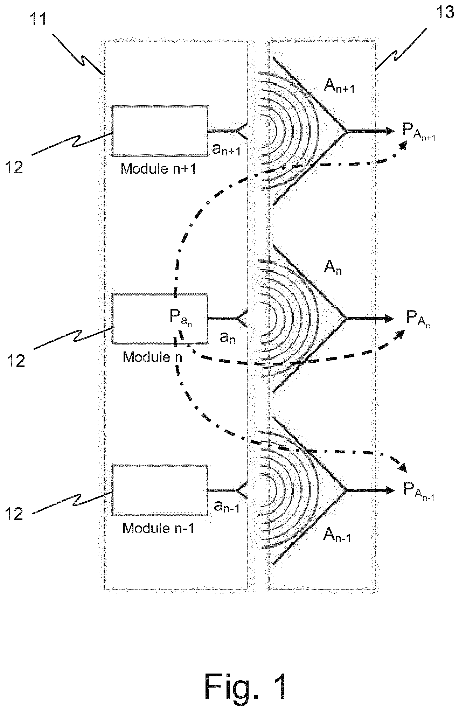

Pour réaliser ces tests, il est connu d'utiliser des systèmes de test 11 dits "en champ proche" qui comportent, comme l'illustre la figure 1, une pluralité de modules de test 12 comportant chacun une antenne de test $a_n$ placée en regard d'une antenne $A_n$ constituant le système de réception 13 considéré, à proximité de cette dernière.

La demande de brevet français déposée par la demanderesse et référencée sous le numéro FR 1700081, décrit un tel système de test. Les documents US2011/077509 A1, US2002/095304 A1, US6215448 B1, JP2009058384 A, DE102016001370 A1, US2007/013607 A1 décrivent aussi des systèmes de test.

En pratique, pour réaliser un test performant avec un tel système de test 11, chaque module 12 du système de test doit être configuré pour émettre de manière privilégiée en direction de l'antenne $A_n$ en regard duquel il se trouve, de telle façon que cette dernière reçoive la plus grande part du signal émis et que la puissance de signal reçue par les antennes voisines de l'antenne $A_n$ considérée soit minimale.

Par ailleurs, pour éviter le plus possible la réception par une antenne sous test $A_n$ d'un signal de test qui ne lui est pas destiné, la réception du signal de test destiné à une antenne voisine en particulier, il est souhaitable de pouvoir placer chacune des antennes de test au plus près de antenne à laquelle elle est associée, de façon à limiter l'éventualité de réceptions parasites.

Cependant les modules de test élémentaires 12 doivent être en même temps configurés de telle façon que le positionnement d'un module de test au voisinage d'une antenne $A_n$ sous test ne soit pas susceptible de perturber le diagramme de rayonnement de cette dernière.

Par ailleurs également, chaque module de test 12 doit pouvoir émettre un signal présentant des caractéristiques en rapport avec les performances à tester, en matière de bande passante notamment.

Par suite, si l'on veut développer un système de test en champ proche vraiment performant en termes de stimulation et provoquant peu d'altération du diagramme de rayonnement des antennes testées, il est nécessaire que chacun des modules 12 du système de test 11 présente une configuration permettant de satisfaire les conditions suivantes :

a) la fréquence du signal de test émis doit pouvoir varier dans une bande de fréquence large correspondant à la gamme de fréquence de fonctionnement des signaux réels reçus par l'antenne testée, une bande comprise entre 0,1 et 40GHz par exemple ;

b) la configuration des modules de test 12 et leur arrangement doivent être tels que le couplage entre un module de test et l'antenne $A_n$ à laquelle il est associé doit être maximal, tandis que le couplage entre ce même module de test 12 et les autres antennes, les antennes au voisinage de l'antenne considérée en particulier, soit minimal ;

c) les caractéristiques de couplage énoncées à l'alinéa précédent doivent être obtenues pour une large bande de fréquence, une bande de fréquence s'étendant typiquement sur plusieurs octaves, sur trois octaves entre 2 GHz et 18 GHz par exemple ;

d) la configuration des modules de test 12 et leur arrangement doivent être tels que la présence d'un module de test introduise une perturbation minimale, ou du moins acceptable, du diagramme de rayonnement de l'antenne $A_n$ à tester correspondante.

On rappelle ici, comme l'illustre la figure 1, que le couplage $C_{A_k,a_n}$ entre une antenne $A_k$ d'un système antennaire 13 et une antenne de test $a_n$ d'un module de test 12 appartenant à un système de test 11, se définit comme le rapport de la puissance $P_{Ak}$ reçue et délivrée par l'antenne $A_k$, à la puissance $P_{a_n}$ injectée dans l'antenne $a_n$, soit :

$$C_{A_k,a_n} = \frac{P_{A_k}}{P_{a_n}} \qquad\qquad [001]$$

Par suite, dans le contexte de la présente demande de brevet, la condition b) énoncée précédemment est considérée comme satisfaite dans la mesure où :

- la valeur du couplage $C_{A_n,a_n}$ entre une antenne $A_n$ sous test et l'antenne $a_n$ du module de test 12 qui lui est associé est de l'ordre de -40dB. Dans une telle configuration le diagramme de rayonnement de l'antenne $A_n$ considéré n'est pas perturbé tandis qu'elle délivre cependant une puissance suffisante au dispositif de réception auquel elle délivre les signaux qu'elle capte ;
- la valeur du couplage $C_{A_k,a_n}$ entre une antenne sous test $A_k$ ($k{\neq}n$) et l'antenne $a_n$ d'un module de test 12 auquel elle n'est pas normalement associée est au moins 20dB plus faible que la valeur du couplage précédent. Une telle configuration garantit que le signal délivré par une antenne sous test $A_n$ provient essentiellement du signal émis par l'antenne $a_n$ du module de test 12 qui lui est associé. Le signal délivré par l'antenne $A_n$ considérée reste ainsi peu parasité par des signaux provenant d'autres modules de test.

En l'état de l'art actuel, il n'existe pas de système de test 11 en champ proche pour un système antennaire 13 qui satisfasse les conditions de fonctionnement optimal, décrites dans le texte qui précède.

*PRESENTATION DE L'INVENTION*

Un but de l'invention est de proposer un moyen de test en champ proche répondant aux exigences énoncées précédemment.

A cet effet l'invention a pour objet une antenne de test $a_n$ pour stimuler une antenne $A_n$ faisant partie d'un système d'antennes.

Ladite antenne de test $a_n$ est décrite dans la revendication 1.

L'invention a également pour objet un dispositif de test pour stimuler une antenne $A_n$ à polarisation rectiligne.

Ledit système de test comporte une antenne de test $a_n$ selon l'invention. Ladite antenne de test est agencée vis-à-vis de l'antenne à stimuler $A_n$ considérée de façon à ce que :

- l'antenne de test $a_n$ soit placée au plus près de l'antenne à stimuler $A_n$ considérée ;
- la projection du contour de l'antenne de test $a_n$ sur le plan de rayonnement de l'antenne à stimuler $A_n$ considérée soit située à l'intérieur du périmètre délimitant cette dernière ;
- l'axe longitudinal de l'antenne de test $a_n$ soit disposé parallèlement au plan rayonnant de l'antenne à stimuler $A_n$ considérée et au plus près de cette dernière ;
- l'axe longitudinal de l'antenne de test soit aligné avec un axe de polarisation rectiligne de l'antenne à stimuler considérée ;
- l'axe longitudinal de l'antenne de test doit couper l'axe passant par le centre de symétrie de l'antenne à stimuler $A_n$ considérée et perpendiculaire au plan rayonnant de cette dernière.

Selon un mode de réalisation particulier, adapté au test d'une antenne à stimuler $A_n$ constituée par un cornet à polarisation rectiligne dont l'ouverture est agencée dans un plan *(xOy)* et dont l'axe de rayonnement est confondu avec un axe *(Oz)* perpendiculaire au plan *(xOy),* l'antenne de test $a_n$ est dimensionnée et agencée vis-à-vis de l'antenne à stimuler $A_n$ considérée de façon à ce que :

- son axe longitudinal coupe l'axe *(Oz)* ;
- la projection de son point *P* sur le plan *(xOy)* soit sur le bord de la zone délimitant la surface de l'antenne à stimuler $(A_n)$ ;
- la projection de son point *E* sur le plan *(xOy)* soit située à l'intérieur de la zone délimitant la surface de l'antenne à stimuler $(A_n)$ ;
- les longueurs $l_1$ et $l_2$ soient sensiblement égales et que leur somme corresponde à une fraction de la dimension de l'antenne à stimuler $A_n$ dans la direction de l'axe longitudinal de l'antenne de test $a_n$.

Selon un autre mode de réalisation particulier, adapté au test d'une antenne à stimuler $A_n$ constituée par une antenne plane à polarisation rectiligne, disposée dans un plan *(xOy)* et dont le centre de symétrie est confondu avec le point O, l'antenne de test $a_n$ est dimensionnée et agencée vis-à-vis de l'antenne à stimuler $A_n$ de façon à ce que son axe longitudinal coupe l'axe *(Oz)* perpendiculaire au plan *(xOy)* au point R; les longueurs $l_1$ et $l_2$ étant telle que leur somme $l_1+l_2$ soit au moins égale à la dimension de la surface de l'antenne à stimuler $A_n$ dans la direction de l'axe longitudinal de l'antenne de test $a_n$.

Selon une forme de mise en œuvre particulière, l'antenne de test $a_n$ est placée contre la surface du radôme protégeant l'antenne à stimuler $A_n$ considérée.

L'invention a également pour objet un dispositif de test d'une antenne à bipolarisation possédant deux polarisations rectilignes orthogonales. Ledit dispositif comporte deux antennes de test selon l'invention. Il comporte également des moyens pour positionner lesdites antennes de test vis-à-vis de l'antenne à stimuler $A_n$ considérée de façon à ce que :

- chaque antenne de test soit placée au plus près de l'antenne à stimuler $A_n$ considérée ;
- la projection du contour de chacune des antennes de test sur le plan rayonnant de l'antenne à stimuler $A_n$ soit située à l'intérieur de la surface délimitant l'antenne à stimuler $A_n$ considérée ;
- l'axe longitudinal de chacune des antennes de test soit disposé parallèlement au plan rayonnant de l'antenne à stimuler $A_n$ et au plus près de cette dernière ;
- les axes longitudinaux des antennes de test soient alignés selon des axes perpendiculaires ;
- l'axe longitudinal de chacune des antennes de test doit couper l'axe passant par le centre de symétrie de l'antenne à stimuler $A_n$ et perpendiculaire au plan rayonnant de cette dernière ;
- les deux antennes de test ne soient pas en contact l'une de l'autre.

Selon un mode de réalisation particulier, adapté au test d'une antenne à stimuler $A_n$ constituée par un cornet à polarisation rectiligne dont l'ouverture est agencée dans un plan *(xOy)* et dont l'axe de rayonnement est confondu avec un axe *(Oz)* perpendiculaire au plan *(xOy),* chacune des antennes de test est dimensionnée et agencée vis-à-vis de l'antenne à stimuler $A_n$ considérée de façon à ce que :

- son axe longitudinal coupe l'axe *(Oz)* ;
- la projection de son point *P* sur le plan *(xOy)* soit sur le bord de la zone délimitant la surface de l'antenne à stimuler $(A_n)$ ;
- la projection de son point *E* sur le plan *(xOy)* soit située à l'intérieur de la zone délimitant la surface de l'antenne à stimuler $(A_n)$ ;
- les longueurs $l_1$ et $l_2$ soient sensiblement égales, et que leur somme corresponde à une fraction de la dimension de l'antenne à stimuler $(A_n)$ dans la direction de l'axe longitudinal de l'antenne de test (81, 82) considérée.

Selon un autre mode de réalisation particulier, adapté au test d'une antenne à stimuler $A_n$ constituée par une antenne plane à polarisation rectiligne, disposée dans un plan *(xOy)* et dont le centre de symétrie est confondu avec le point O, chacune des antennes de test est dimensionnée et agencée vis-à-vis de l'aérien de telle façon que son axe longitudinal coupe l'axe *(Oz)* perpendiculaire au plan *(xOy)* au point *R* et que la somme $l_1+l_2$ soit au moins égale à la dimension de la surface de l'antenne à stimuler $A_n$ dans la direction de l'axe longitudinal de l'antenne de test considérée.

L'invention a également pour objet un système de test pour stimuler une pluralité d'antennes, qui comporte une pluralité de dispositifs de test selon l'invention, lesdits dispositifs étant agencés de façon à ce que chaque dispositif de test soit placé en regard d'une antenne à stimuler $A_n$ de ladite pluralité d'antennes.

DESCRIPTION DES FIGURES

Les caractéristiques et avantages de l'invention seront mieux appréciés grâce à la description qui suit, description qui s'appuie sur les figures annexées qui présentent :

la figure 1, un schéma synoptique permettant de présenter le problème technique auquel l'invention propose une solution ;
la figure 2, une illustration schématique d'un mode de réalisation d'une antenne de test ;
la figure 3, une illustration schématique d'un mode de réalisation d'une antenne de test selon l'invention ;
la figure 4, une illustration détaillant la structure de l'antenne de la figure 3 ;
les figures 5 et 6, des illustrations schématiques relatives à la mise en œuvre de l'antenne de test selon l'invention pour le test d'antennes à polarisation rectiligne ;
les figures 7 et 8, des illustrations schématique relatives à la mise en œuvre de l'antenne de test selon l'invention pour le test d'antennes à bipolarisation rectiligne.

Il est à noter que, sur les figures annexées, un même élément fonctionnel ou structurel porte de préférence un même symbole repère.

*DESCRIPTION DETAILLEE*

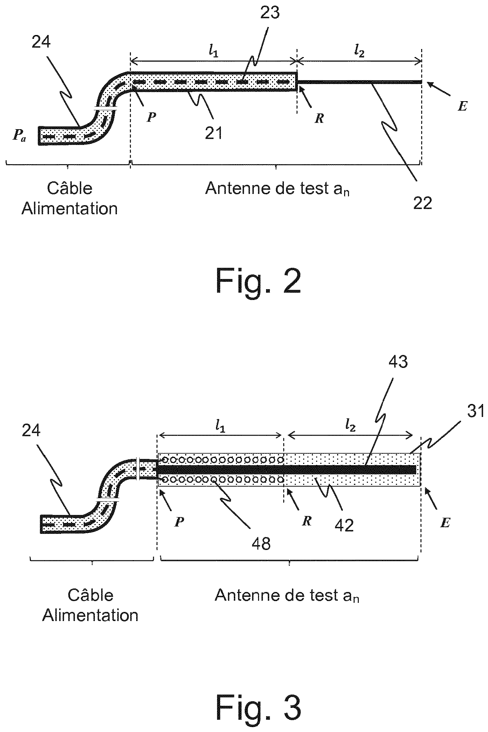

Comme illustré dans la figure 3, l'invention consiste principalement à utiliser une forme d'antenne de test $a_n$ particulière et à placer l'antenne de test $a_n$ au plus près de l'antenne $A_n$ (en zone de champ proche) pour assurer un couplage entre ces deux antennes. De manière préférentielle lorsque l'antenne à tester est protégée par un radôme, l'antenne de test est placée sur la paroi externe du radôme.

Une antenne de test $a_n$ selon l'invention comprend deux sections disposée colinéairement. Une première section 21, de longueur $l_1$, dont la structure correspond à celle d'une ligne de transmission rectiligne et une seconde section 22, de longueur $l_2$, constituée par un segment conducteur rectiligne. L'antenne ainsi constituée est reliée à un câble d'alimentation 24 le long duquel le signal s(t) produit par le module de test 12 transite jusqu'à l'antenne de test $a_n$.

Dans le mode de réalisation de la figure 2, la section 21 est formée par un tronçon de ligne coaxiale, tandis que la section 22 ou "fouet", est formée par une tige conductrice droite dont une extrémité est reliée électriquement et mécaniquement à l'âme de la ligne coaxiale en un point d'extrémité R. Le tronçon de ligne coaxiale 21 et la tige conductrice 22 sont par ailleurs alignés.

Dans une forme de réalisation particulière ne faisant pas partie de l'invention, l'antenne de test $a_n$ est constituée par une ligne coaxiale présentant un segment rectiligne de longueur $l_1 + l_2$, dont une section est dénudée sur une longueur $l_2$ l'âme de la ligne coaxiale constituant la tige conductrice 22. Ledit segment rectiligne présente une extrémité $P$ qui correspond au pied de l'antenne $a_n$, par laquelle il est relié au module de test 12, et une extrémité $E$ correspondant à l'extrémité de la tige conductrice 22 opposée au point $R$.

Par ailleurs une portion 24 de la ligne coaxiale s'étendant depuis l'extrémité $P$ constitue le câble d'alimentation de l'antenne, de sorte que tous les éléments de l'antenne de test sont ainsi avantageusement formés à partir d'une seule ligne coaxiale.

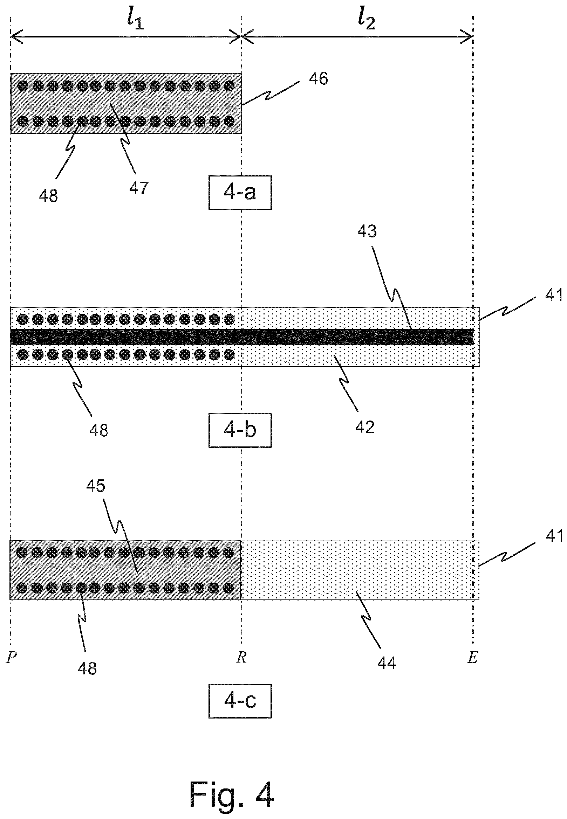

Dans le mode de réalisation faisant partie de l'invention illustré par les figures 3 et 4, l'antenne de test $a_n$ est constituée par un circuit imprimé 31 de structure triplaque de longueur $l_1 + l_2$.

Comme l'illustre de manière détaillée la figure 4, cette structure triplaque 31 comporte un premier substrat diélectrique 41 longiligne de longueur $l_1 + l_2$ sur une face 42 duquel est positionnée une piste conductrice rectiligne à ruban 43 s'étendant d'une extrémité $P$ à l'autre extrémité $E$ du substrat 41. L'autre face du substrat 41 est métallisée sur une portion 45 de longueur $l_1$ s'étendant depuis l'extrémité $P$ jusqu'à un point $R$.

La structure triplaque 31 comporte également un second substrat diélectrique 46 de longueur $l_1$, présentant une face 47 totalement métallisée.

Ce second substrat 46 est assemblé avec l'autre substrat 41 de telle façon que la face non métallisée du second substrat soit placée contre la face 42 du premier substrat 41 portant la piste conductrice 43, au niveau de la zone métallisée 45 de l'autre face 44 du premier substrat.

L'assemblage, qui peut être réalisé par tout moyen connu par l'homme de l'art, est complété par la présence de vias conducteurs 48, implantés le long des bords latéraux des deux substrats 41 et 46, qui relient électriquement la face métallisée 45 du premier substrat 41 à la face métallisée 47 du second substrat 46. On obtient ainsi avantageusement une structure en sandwich s'étendant sur une longueur $l_1$ qui permet une transmission guidée des signaux entre les points $P$ et $R$.

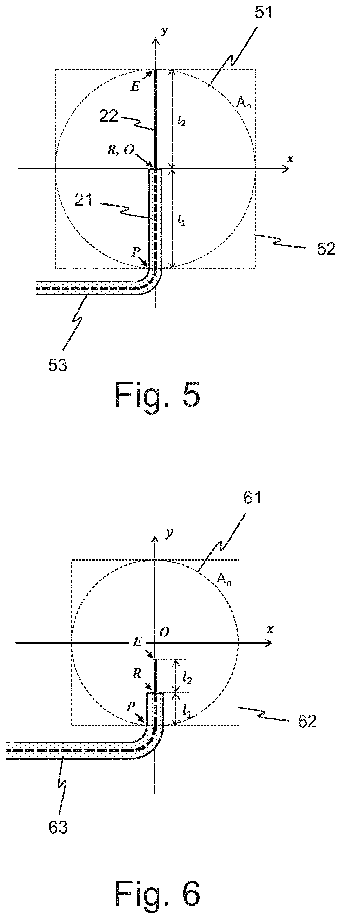

Les figures 5 et 6 illustrent deux modes de mise en œuvre d'une antenne de test selon l'invention. La figure 5 illustre un mode de mise en œuvre adapté au test d'une antenne plane, de type antenne ruban par exemple, tandis que la figure 6 illustre un mode de mise en œuvre adapté au test d'une antenne à ouverture rayonnante, constituée par un cornet rayonnant par exemple.

Ces deux modes de mise en œuvre permettent de réaliser le test d'une antenne en ne considérant qu'un seul axe de polarisation.

De manière générale, la détermination des dimensions d'une antenne de test $a_n$ selon l'invention, ainsi que la détermination de son positionnement et de son orientation par rapport à l'antenne $A_n$ à tester, présentent un caractère critique.

Elle exige, en particulier, de connaître le type d'antenne auquel appartient l'antenne $A_n$ à tester (i.e. une antenne filaire plane, comme par exemple une antenne spirale, une antenne sinueuse ou encore une antenne papillon, ou bien une antenne en volume, à ouverture rayonnante, comme par exemple un cornet), la géométrie de cette antenne ainsi que son agencement au sein du système antennaire dont elle fait partie.

La figure 5 montre comment sont déterminés ces paramètres de configuration et d'agencement d'une antenne de test 53 selon l'invention dans le cas où l'antenne An à tester est une antenne filaire plane.

Sur l'illustration de la figure 5, l'antenne $A_n$ est figurée par une forme en traits discontinus, un cercle 51 ou un carré 52 par exemple selon sa géométrie, qui délimite son étendue dans le plan *(xOy), O* étant son centre. L'axe de rayonnement de l'antenne considérée ici est supposé être un axe (*Oz*) (non représenté sur la figure) orthogonal au plan *(xOy)* et dirigé vers l'avant de la figure (vers l'observateur).

Dans un tel contexte les paramètres de configuration et d'agencement d'une antenne de test 53 sont déterminés en prenant en compte les critères dimensionnants suivants :

D'un point de vue agencement, l'antenne de test $a_n$ doit être positionnée au plus près du plan *(xOy)* compte tenu des épaisseurs respectives des radômes, côté module récepteur de test et côté antenne sous test.

L'axe longitudinal de l'antenne de test 53 doit, par ailleurs, être parallèle au plan *(xOy)* et aligné avec l'axe de polarisation rectiligne de l'antenne $A_n$ ou, le cas échéant, avec un des axes de polarisation rectiligne.

Il doit, en outre, couper l'axe (*Oz*) au point *R* défini précédemment.

D'un point de vue dimensionnel, les longueurs $l_1$ et $l_2$ définissant l'antenne de test 53 doivent permettre à l'antenne de test 53 de couvrir l'antenne $A_n$ à tester, autrement dit l'antenne de test $a_n$ et les longueurs $l_1$ et $l_2$ doivent être définies de telle façon que les projections des points *P* et *E* sur le plan *(xOy)* se situent sur le périmètre 51 ou 52 délimitant l'étendue de l'antenne $A_n$ dans le plan *(xOy)* ou bien au-delà de ce périmètre.

Il est à noter ici que, dans la mesure où le point *O* représente le centre de symétrie de l'antenne plane $A_n$ les longueurs $l_1$ et $l_2$ sont égales.

Cependant, dans la mesure très particulière où *O* ne serait pas un centre de symétrie, les longueurs $l_1$ et $l_2$ seraient alors différentes et on choisirait préférentiellement $l_2$ de telle façon que *R* soit aligné avec *O* le long de l'axe (*Oz*).

Il est à noter également que les critères dimensionnants listés précédemment, en particulier les valeurs respectives des longueurs $l_1$ et $l_2$, correspondent aux cas d'antennes classiques de type spirale, sinueuse ou papillon qui peuvent être délimitées par un contour circulaire ou carré. Cependant, on conçoit aisément que ces critères dimensionnels puissent être adaptés, mutatis mutandis, aux cas d'antennes planes de formes moins conventionnelles pouvant par exemple être délimitées par une ellipse ou un rectangle.

La figure 6 montre comment sont déterminés les paramètres de configuration et d'agencement d'une antenne de test 63 selon l'invention dans le cas où l'antenne $A_n$ à tester est une antenne à ouverture rayonnante de type cornet.

Sur l'illustration de la figure 6, l'ouverture de l'antenne $A_n$ est figurée par une forme en traits discontinus, située dans le plan *(xOy)* de cette dernière, un cercle 61 ou un carré 62 par exemple selon sa géométrie; *O* étant le centre de cette ouverture.

Comme dans le mode de mise en œuvre précédent, l'axe de rayonnement de l'antenne considérée ici est supposé être un axe (*Oz*) (non représenté sur la figure) orthogonal au plan *(xOy)* et dirigé vers l'avant de la figure (vers l'observateur).

Dans un tel contexte les paramètres de configuration et d'agencement d'une antenne de test 63 sont déterminés en prenant en compte les critères dimensionnants suivants:

D'un point de vue agencement l'antenne de test $a_n$ doit être positionnée au plus près du plan *(xOy)* compte tenu des épaisseurs respectives des radômes, côté module récepteur de test et côté antenne sous test.

L'axe longitudinal de l'antenne de test 63 doit, par ailleurs, être parallèle au plan *(xOy)* et aligné avec l'axe de polarisation rectiligne de l'antenne $A_n$ ou, le cas échéant, avec un des axes de polarisation rectiligne.

Il doit, en outre, couper l'axe (*Oz*).

D'un point de vue dimensionnel, les longueurs $l_1$ et $l_2$ définissant l'antenne de test 63 doivent permettre à l'antenne de test $a_n$ d'être couverte par l'antenne $A_n$ à tester, autrement dit l'antenne de test $a_n$ et les longueurs $l_1$ et $l_2$ doivent être définies de telle façon que :

- la projection du point *P* sur le plan *(xOy)* se situe sur le périmètre 61 ou 62 délimitant l'ouverture de l'antenne $A_n$ dans le plan *(xOy)* ;

- la projection du point *E* sur le plan *(xOy)* se situe à l'intérieur du périmètre 51 ou 52 délimitant l'ouverture de l'antenne $A_n$ ;

- les longueurs $l_1$ et $l_2$ doivent être sensiblement égales et leur somme doit être une fraction de la distance séparant les points d'intersection du périmètre 61 ou 62 délimitant l'ouverture de l'antenne $A_n$ avec la direction de l'axe longitudinal de l'antenne de test 63, à un quart ou à un tiers de cette distance par exemple.

Il est à noter que, si les figures 5 et 6 illustrent deux modes de mise en œuvre d'une antenne de test selon l'invention en faisant figurer une antenne constituée par un ligne coaxiale, il n'en reste pas moins que tout ce qui vient d'être exposé dans les commentaires associés à ces figures s'applique sans restriction au cas où l'antenne de test 53 ou 63 mise en œuvre est une antenne triplaque telle que l'antenne 31 illustrée par les figures 3 et 4.

Les modes de mise en œuvre illustrés par les figures 5 et 6 considèrent que l'antenne $A_n$ est une antenne à polarisation rectiligne présentant au moins un axe de polarisation. Par suite, l'antenne de test 53 ou 63 est agencée vis-à-vis de l'antenne $A_n$ de telle façon que son axe longitudinal soit aligné sur cet axe de polarisation.

Il faut cependant considérer que les caractéristiques de dimensionnement et d'agencement présentées par l'antenne de test selon l'invention dans ces deux modes de mise en œuvre peuvent être facilement adaptées au cas du test d'une antenne plane à polarisation circulaire, une antenne spirale par exemple.

Dans ce cas, aucun axe d'orientation privilégié de l'axe longitudinal de l'antenne de test ne peut être considéré. Par suite, il n'y aura pas d'axe d'alignement privilégié pour le couplage avec l'antenne $A_n$. On peut alors choisir l'orientation de l'axe longitudinal de l'antenne de test en considérant d'autres critères, en choisissant par exemple une orientation minimisant la gêne occasionnée aux antennes voisines de l'antenne $A_n$ considérée.

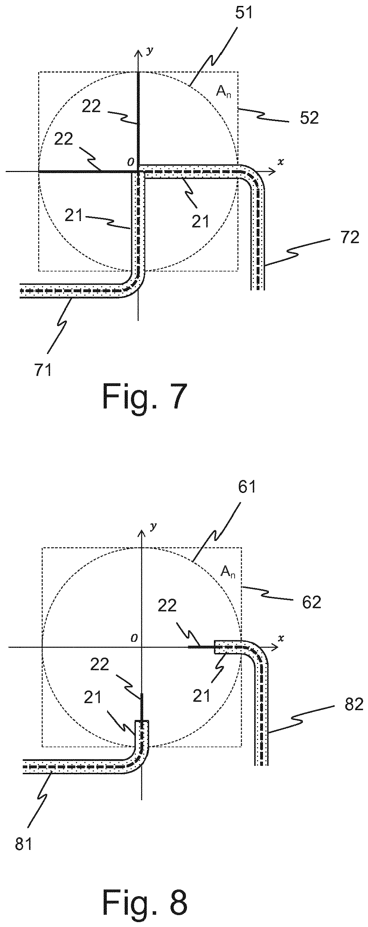

Les figures 7 et 8 illustrent deux autres modes de mise en œuvre de l'antenne de test selon l'invention pour réaliser le test d'une antenne en considérant deux axes de polarisation. La figure 7 illustre le cas où l'antenne considérée est une antenne plane, comme dans le cas de la figure 5, tandis que la figure 8 illustre le cas d'une antenne à ouverture rayonnante.

Ces modes de mise en œuvre supposent la mise en place de deux antennes, les antennes 71 et 72 ou 81 et 82 selon le mode considéré, orientées chacune suivant un des axes de polarisation.

Ces antennes présentent chacune en fonction de la nature de l'antenne $A_n$ à tester, antenne plane ou antenne à ouverture rayonnante, les caractéristiques respectives décrites précédemment.

Cependant, pour ces deux modes de mise en œuvre, on doit répondre à une contrainte d'agencement supplémentaire consistant, comme illustré par les figure 7 et 8, en ce que les deux antennes de test, 71 et 72 ou 81 et 82 selon le mode considéré, ne soient pas en contact l'une de l'autre, tant au niveau des sections 21 (sections guidées) qu'au niveau des sections 22 (éléments conducteurs nus).

Les modes de mise en œuvre des figures 7 et 8 permettent ainsi avantageusement de stimuler une antenne $A_n$ à bipolarisation rectiligne, en utilisant simplement deux antennes de test selon l'invention, agencées conformément aux règles d'alignement ou d'orientation d'une antenne $a_n$ selon une polarisation rectiligne. Cependant, ils permettent également de stimuler de manière optimale une antenne $A_n$ de polarisation circulaire. Pour ce faire on induit un déphasage en quadrature au niveau des signaux rayonnés ou captés par les deux antennes de test, au moyen par exemple d'un coupleur hybride placé entre les deux antennes.

**Revendications**

1. Antenne de test ($a_n$) pour stimuler une antenne ($A_n$) à polarisation rectiligne, **caractérisée en ce qu'**elle comporte un premier segment (21) de longueur $l_1$ s'étendant entre un point $P$ et un point $R$ et formant une structure guidée rectiligne, et un second segment (22) formé par un élément conducteur rectiligne de longueur $l_2$ s'étendant entre le point $R$ et un point d'extrémité $E$, le second segment (22) étant placé dans le prolongement du premier segment (21) de façon à former une structure rectiligne, ladite antenne de test ($a_n$) comprenant un circuit imprimé triplaque (31) comprenant deux substrats diélectriques (41, 46) :

    - un premier substrat (41) ayant une face (42) pourvue d'une piste conductrice rectiligne (43) de longueur l1+l2 s'étendant entre les deux points P et E, son autre face (44) étant métallisée sur une longueur l1 (45)
    - un second substrat (46), de longueur l1, ayant une face dépourvue de tout conducteur, son autre face (47) étant métallisée, le second substrat (46) étant monté sur le premier substrat (41), de telle façon que sa face non métallisée soit au contact de la face (42) du premier substrat (41) pourvue de la piste conductrice rectiligne (43) ;

    les deux faces métallisées (45, 47) des deux substrats étant électriquement reliées l'une à l'autre par l'intermédiaire de vias conducteurs (48).

2. Antenne de test selon la revendication précédente, dans lequel les vias conducteurs sont implantés le long de bords latéraux du premier substrat et du second substrat qui relient électriquement la face métallisée (45) du premier substrat (41) à la face métallisée (47) du second substrat (46).

3. Dispositif de test pour stimuler une antenne ($A_n$) à polarisation rectiligne, **caractérisé en ce qu'**il comporte une antenne de test (53, 63) selon l'une quelconque des revendications 1 à 2 et une antenne à stimuler (An), ladite antenne de test étant agencée vis-à-vis de l'antenne à stimuler ($A_n$) considérée de façon à ce que :

    - l'antenne de test (53, 63) soit placée en champ proche de l'antenne à stimuler considérée ;
    - la projection du contour de l'antenne de test (53, 63) sur le plan de rayonnement de l'antenne à stimuler ($A_n$) considérée soit située à l'intérieur du périmètre (51-52, 61-62) délimitant cette dernière ;
    - l'axe longitudinal de l'antenne de test (53, 63) soit disposé parallèlement au plan rayonnant de l'antenne à

stimuler ($A_n$) considérée et au plus près de cette dernière ;
- l'axe longitudinal de l'antenne de test (53, 63) soit aligné avec un axe de polarisation rectiligne de l'antenne à stimuler ($A_n$) considérée ;
- l'axe longitudinal de l'antenne de test (53, 63) coupe l'axe passant par le centre de symétrie de l'antenne à stimuler ($A_n$) considérée et perpendiculaire au plan rayonnant de cette dernière.

4. Dispositif de test selon la revendication 3, **caractérisé en ce que** l'antenne à stimuler ($A_n$) étant un cornet à polarisation rectiligne dont l'ouverture est agencée dans un plan *(xOy)* et dont l'axe de rayonnement est confondu avec un axe *(Oz)* perpendiculaire au plan *(xOy)*, l'antenne de test (63) est dimensionnée et agencée vis-à-vis de l'antenne à stimuler ($A_n$) considérée de façon à ce que :

   - son axe longitudinal coupe l'axe *(Oz)* ;
   - la projection de son point *P* sur le plan *(xOy)* soit sur le bord de la zone délimitant la surface de l'antenne à stimuler ($A_n$) ;
   - la projection de son point *E* sur le plan *(xOy)* soit située à l'intérieur de la zone délimitant la surface de l'antenne à stimuler ($A_n$) ;
   - les longueurs $l_1$ et $l_2$ étant sensiblement égales et leur somme correspondant à une fraction de la dimension de l'antenne à stimuler ($A_n$) dans la direction de l'axe longitudinal de l'antenne de test (63).

5. Dispositif de test selon la revendication 3, **caractérisé en ce que** l'antenne à stimuler ($A_n$) étant une antenne plane à polarisation rectiligne disposée dans un plan *(xOy)* et dont le centre de symétrie est confondu avec le point *O* l'antenne de test (53) est dimensionnée et agencée vis-à-vis de l'antenne à stimuler ($A_n$) de façon à ce que son axe longitudinal coupe l'axe *(Oz)* perpendiculaire au plan *(xOy)* au point *R*; les longueurs $l_1$ et $l_2$ étant telle que leur somme $l_1+l_2$ soit au moins égale à la dimension de la surface de l'antenne à stimuler ($A_n$) dans la direction de l'axe longitudinal de l'antenne de test (53).

6. Dispositif de test selon l'une des revendications 3 à 5, comprenant un radôme protégeant l'antenne à stimuler considérée, l'antenne de test (53, 63) est placée contre la surface du radôme protégeant l'antenne à stimuler ($A_n$) considérée.

7. Dispositif de test pour stimuler une antenne à stimuler à bipolarisation possédant deux polarisations rectilignes orthogonales, **caractérisé en ce qu'**il comporte deux antennes de test (71-72, 81-82) selon l'une quelconque des revendications 1 à 2 et une antenne à stimuler (An), et des moyens pour positionner lesdites antennes de test vis-à-vis de l'antenne à stimuler ($A_n$) considérée de façon à ce que :

   - chaque antenne de test (71-72, 81-82) soit placée en champ proche de l'antenne à stimuler ($A_n$) considérée ;
   - la projection du contour de chacune des antennes de test (71-72, 81-82) sur le plan rayonnant de l'antenne à stimuler ($A_n$) soit située à l'intérieur de la surface délimitant l'antenne à stimuler ($A_n$) considérée ;
   - l'axe longitudinal de chacune des antennes de test (71-72, 81-82) soit disposé parallèlement au plan rayonnant de l'antenne à stimuler ($A_n$) et au plus près de cette dernière ;
   - les axes longitudinaux des antennes de test (71-72, 81-82) soient alignés selon des axes perpendiculaires ;
   - l'axe longitudinal de chacune des antennes de test (71-72, 81-82) coupe l'axe passant par le centre de symétrie de l'antenne à stimuler ($A_n$) et perpendiculaire au plan rayonnant de cette dernière ;
   - les deux antennes de test (71-72, 81-82) ne soient pas en contact l'une de l'autre.

8. Dispositif de test selon la revendication précédente, **caractérisé en ce que** l'antenne à stimuler ($A_n$) étant un cornet bipolarisation possédant deux polarisations rectilignes orthogonales, dont l'ouverture est agencée dans un plan *(xOy)* et dont l'axe de symétrie est confondu avec un axe *(Oz)* perpendiculaire au plan *(xOy)*, chacune des antennes de test (81, 82) est dimensionnée et agencée vis-à-vis de l'antenne à stimuler ($A_n$) considérée de façon à ce que :

   - son axe longitudinal coupe l'axe *(Oz)* ;
   - la projection de son point *P* sur le plan *(xOy)* soit sur le bord de la zone délimitant la surface de l'antenne à stimuler ($A_n$) ;
   - la projection de son point *E* sur le plan *(xOy)* soit située à l'intérieur de la zone délimitant la surface de l'antenne à stimuler ($A_n$) ;
   - les longueurs $l_1$ et $l_2$ étant sensiblement égales, leur somme correspond à une fraction de la dimension de l'antenne à stimuler ($A_n$) dans la direction de l'axe longitudinal de l'antenne de test (81, 82) considérée.

**9.** Dispositif de test selon la revendication 7, **caractérisé en ce que** l'antenne à stimuler ($A_n$) étant une antenne plane bipolarisation possédant deux polarisations rectilignes orthogonales disposée dans un plan *(xOy)* et dont le centre de symétrie est confondu le point *O*, chacune des antennes de test (71, 72) est dimensionnée et agencée vis-à-vis de l'aérien de telle façon que son axe longitudinal coupe l'axe *(Oz)* perpendiculaire au plan *(xOy)* au point *R*; les longueurs $l_1$ et $l_2$ étant telles que leur somme $l_1+l_2$ soit au moins égale à la dimension de la surface de l'antenne à stimuler ($A_n$) dans la direction de l'axe longitudinal de l'antenne de test (71, 72) considérée.

**10.** Système de test pour stimuler une pluralité d'antennes, **caractérisé en ce qu'**il comporte une pluralité de dispositifs de test selon l'une des revendications 3 à 9, lesdits dispositifs étant agencés de façon à ce que chaque dispositif de test soit placé en regard d'une antenne à stimuler ($A_n$) de ladite pluralité d'antennes.


**Patentansprüche**

**1.** Testantenne ($a_n$) zum Stimulieren einer Antenne ($A_n$) mit linearer Polarisation, **dadurch gekennzeichnet, dass** sie ein erstes Segment (21) mit der Länge $l_1$, das sich zwischen einem Punkt *P* und einem Punkt *R* erstreckt und eine lineare geleitete Struktur bildet, und ein zweites Segment (22) aufweist, das durch ein lineares leitendes Element mit der Länge $l_2$ gebildet wird, das sich zwischen dem Punkt *R* und einem Endpunkt *E* erstreckt, wobei das zweite Segment (22) in der Verlängerung des ersten Segments (21) angeordnet ist, um eine lineare Struktur zu bilden, wobei die Testantenne ($a_n$) eine Triplate-Leiterplatte (31) mit zwei dielektrischen Substraten (41, 46) umfasst:

- wobei ein erstes Substrat (41) eine Seite (42) hat, die mit einer linearen Leiterbahn (43) der Länge l1+l2 versehen ist, die sich zwischen den beiden Punkten P und E erstreckt, wobei die andere Seite (44) über eine Länge 11 (45) metallisiert ist;
- ein zweites Substrat (46) der Länge 11, dessen eine Seite frei von jeglichen Leitern ist und dessen andere Seite (47) metallisiert ist, wobei das zweite Substrat (46) so auf dem ersten Substrat (41) montiert ist, dass seine nichtmetallisierte Seite mit der mit der linearen Leiterbahn (43) versehenen Seite (42) des ersten Substrats (41) in Kontakt ist;

wobei die beiden metallisierten Seiten (45, 47) der beiden Substrate über Durchkontaktierungen (48) elektrisch miteinander verbunden sind.

**2.** Testantenne nach dem vorherigen Anspruch, wobei die Durchkontaktierungen entlang der Seitenränder des ersten Substrats und des zweiten Substrats implantiert sind, die die metallisierte Fläche (45) des ersten Substrats (41) mit der metallisierten Fläche (47) des zweiten Substrats (46) elektrisch verbinden.

**3.** Testvorrichtung zum Stimulieren einer Antenne ($A_n$) mit linearer Polarisation, **dadurch gekennzeichnet, dass** sie eine Testantenne (53, 63) nach einem der Ansprüche 1 bis 2 und eine zu stimulierende Antenne ($A_n$) umfasst, wobei die Testantenne gegenüber der zu stimulierenden Antenne ($A_n$) so angeordnet ist, dass:

- die Testantenne (53, 63) im Nahfeld der betrachteten zu stimulierenden Antenne angeordnet ist;
- die Projektion der Kontur der Testantenne (53, 63) auf die Strahlungsebene der betrachteten zu stimulierenden Antenne ($A_n$) sich innerhalb des diese begrenzenden Perimeters (51-52, 61-62) befindet;
- die Längsachse der Testantenne (53, 63) parallel zur Strahlungsebene der betrachteten zu stimulierenden Antenne ($A_n$) und so nah wie möglich an dieser angeordnet ist;
- die Längsachse der Testantenne (53, 63) mit einer linearen Polarisationsachse der betrachteten zu stimulierenden Antenne ($A_n$) ausgerichtet ist;
- die Längsachse der Testantenne (53, 63) eine Achse schneidet, die durch das Symmetriezentrum der betrachteten zu stimulierenden Antenne (An) verläuft und lotrecht zu deren Strahlungsebene steht.

**4.** Testvorrichtung nach Anspruch 3, **dadurch gekennzeichnet, dass** die zu stimulierende Antenne (An) ein linear polarisiertes Horn ist, dessen Öffnung in einer Ebene *(xOy)* angeordnet ist und dessen Strahlungsachse mit einer Achse *(Oz)* lotrecht zur Ebene *(xOy)* zusammenfällt, wobei die Testantenne (63) gegenüber der betrachteten zu stimulierenden Antenne (An) so dimensioniert und angeordnet ist, dass:

- ihre Längsachse die Achse *(Oz)* schneidet;
- die Projektion ihres Punkts *P* auf die *(xOy)*-Ebene auf dem Rand der Zone liegt, die die Oberfläche der zu stimulierenden Antenne ($A_n$) begrenzt;

- die Projektion ihres Punkts *E* auf die (*xOy*)-Ebene innerhalb der Zone liegt, die die Oberfläche der zu stimulierenden Antenne (A$_n$) begrenzt;
- die Längen $l_1$ und $l_2$ im Wesentlichen gleich sind und ihre Summe einem Bruchteil der Abmessung der zu stimulierenden Antenne (A$_n$) in Richtung der Längsachse der Testantenne (63) entspricht.

**5.** Testvorrichtung nach Anspruch 3, **dadurch gekennzeichnet, dass** die zu stimulierende Antenne (A$_n$) eine Flachantenne mit linearer Polarisation ist, die in einer Ebene *(xOy)* angeordnet ist und deren Symmetriezentrum mit dem Punkt *O* zusammenfällt, die Testantenne (53) so dimensioniert und gegenüber der zu stimulierenden Antenne (A$_n$) so angeordnet ist, dass ihre Längsachse die Achse (*Oz*) lotrecht zur Ebene (*xOy*) im Punkt *R* schneidet; wobei die Längen $l_1$ und $l_2$ derart sind, dass ihre Summe $l_1+l_2$ mindestens gleich der Abmessung der Oberfläche der zu stimulierenden Antenne (A$_n$) in Richtung der Längsachse der Testantenne (53) ist.

**6.** Testvorrichtung nach einem der Ansprüche 3 bis 5, die ein Radom umfasst, das die betrachtete zu stimulierende Antenne schützt, wobei die Testantenne (53, 63) an der Oberfläche des die betrachtete zu stimulierende Antenne (A$_n$) schützenden Radoms platziert ist.

**7.** Testvorrichtung zum Stimulieren einer zu stimulierenden bipolarisierten Antenne mit zwei orthogonalen linearen Polarisationen, **dadurch gekennzeichnet, dass** sie zwei Testantennen (71-72, 81-82) nach einem der Ansprüche 1 bis 2 und eine zu stimulierende Antenne (An) sowie Mittel zur Positionierung der Testantennen gegenüber der betrachteten zu stimulierenden Antenne (A$_n$) umfasst, so dass:

- jede Testantenne (71-72, 81-82) im Nahfeld der betrachteten zu stimulierenden Antenne (A$_n$) positioniert ist;
- die Projektion der Kontur jeder der Testantennen (71-72, 81-82) auf die Strahlungsebene der zu stimulierenden Antenne (A$_n$) innerhalb der Oberfläche liegt, die die betrachtete zu stimulierende Antenne (A$_n$) begrenzt;
- die Längsachse jeder der Testantennen (71-72, 81-82) parallel zur Strahlungsebene der zu stimulierenden Antenne (A$_n$) und so nah wie möglich an dieser angeordnet ist;
- die Längsachsen der Testantennen (71-72, 81-82) gemäß lotrechten Achsen ausgerichtet sind;
- die Längsachse jeder der Testantennen (71-72, 81-82) die Achse schneidet, die durch das Symmetriezentrum der zu stimulierenden Antenne (A$_n$) verläuft und lotrecht zu deren Strahlungsebene steht;
- die beiden Testantennen (71-72, 81-82) nicht in Kontakt miteinander sind.

**8.** Testvorrichtung nach dem vorherigen Anspruch, **dadurch gekennzeichnet, dass** die zu stimulierende Antenne (A$_n$) ein bipolarisiertes Horn mit zwei orthogonalen linearen Polarisationen ist, dessen Öffnung in einer Ebene *(xOy)* angeordnet ist und dessen Symmetrieachse mit einer Achse *(Oz)* lotrecht zur Ebene *(xOy)* zusammenfällt, wobei jede der Testantennen (81, 82) so dimensioniert und gegenüber der betrachteten zu stimulierenden Antenne (A$_n$) angeordnet ist, dass:

- ihre Längsachse die Achse (*Oz*) schneidet;
- die Projektion ihres Punkts *P* auf die Ebene *(xOy)* auf dem Rand der Zone liegt, die die Oberfläche der zu stimulierenden Antenne (A$_n$) begrenzt;
- die Projektion ihres Punkts *E* auf die (*xOy*)-Ebene innerhalb der Zone liegt, die die Oberfläche der zu stimulierenden Antenne (A$_n$) begrenzt;
- da die Längen $l_1$ und $l_2$ im Wesentlichen gleich sind, ihre Summe einem Bruchteil der Abmessung der zu stimulierenden Antenne (A$_n$) in Richtung der Längsachse der betrachteten Testantenne (81, 82) entspricht.

**9.** Testvorrichtung nach Anspruch 7, **dadurch gekennzeichnet, dass** die zu stimulierende Antenne (A$_n$) eine bipolarisierte Flachantenne mit zwei orthogonalen linearen Polarisationen ist, die in einer Ebene *(xOy)* angeordnet ist und deren Symmetriezentrum mit dem Punkt *O* zusammenfällt, wobei jede der Testantennen (71, 72) so dimensioniert und gegenüber der Luftebene angeordnet ist, dass ihre Längsachse die Achse (*Oz*) lotrecht zur Ebene (*xOy*) im Punkt R schneidet; wobei die Längen $l_1$ und $l_2$ derart sind, dass ihre Summe $l_1+l_2$ mindestens gleich der Abmessung der Oberfläche der zu stimulierenden Antenne (A$_n$) in Richtung der Längsachse der betrachteten Testantenne (71, 72) ist.

**10.** Testsystem zum Stimulieren einer Vielzahl von Antennen, **dadurch gekennzeichnet, dass** es eine Vielzahl von Testvorrichtungen nach einem der Ansprüche 3 bis 9 umfasst, wobei die Vorrichtungen so angeordnet sind, dass jede Testvorrichtung gegenüber einer zu stimulierenden Antenne (A$_n$) der Antennengruppe angeordnet ist.

**Claims**

1. A test antenna ($a_n$) for stimulating an antenna ($A_n$) with linear polarisation, **characterised in that** it comprises a first segment (21), which has a length $l_1$ and which extends between a point $P$ and a point $R$ and which forms a rectilinear guided structure, and a second segment (22), which is formed by a rectilinear conductive element which has a length $l_2$ and which extends between the point $R$ and an end point $E$, the second segment (22) being placed in the extension of the first segment (21) in order to form a rectilinear structure, the test antenna ($a_n$) comprising a triplate printed circuit (31) comprising two dielectric substrates (41, 46):

   - a first substrate (41) which has a face (42) which is provided with a rectilinear conductive track (43) which has a length 11 + 12 and which extends between the two points P and E, the other face (44) thereof being metal-coated over a length 11 (45);
   - a second substrate (46), having a length 11 and having a face which has no conductor, the other face (47) thereof being metal-coated, the second substrate (46) being mounted on the first substrate (41) so that the non-metal-coated face thereof is in contact with the face (42) of the first substrate (41) which is provided with the rectilinear conductive track (43);

   the two metal-coated faces (45, 47) of the two substrates being electrically connected to each other by means of conductive vias (48).

2. The test antenna according to the preceding claim, wherein the conductive vias are fitted along lateral edges of the first substrate and the second substrate which electrically connect the metal-coated face (45) of the first substrate (41) to the metal-coated face (47) of the second substrate (46).

3. A test device for stimulating an antenna ($A_n$) with linear polarisation, **characterised in that** it comprises a test antenna (53, 63) according to either claim 1 or claim 2 and an antenna ($A_n$) to be stimulated, the test antenna being arranged with regard to the antenna ($A_n$) to be stimulated in question so that:

   - the test antenna (53, 63) is placed in the near field of the antenna to be stimulated in question;
   - the projection of the contour of the test antenna (53, 63) on the radiation plane of the antenna ($A_n$) to be stimulated in question is located inside the perimeter (51-52, 61-62) which delimits it;
   - the longitudinal axis of the test antenna (53, 63) is arranged parallel with the radiating plane of the antenna ($A_n$) to be stimulated in question and as close as possible thereto;
   - the longitudinal axis of the test antenna (53, 63) is aligned with a linear polarisation axis of the antenna ($A_n$) to be stimulated in question;
   - the longitudinal axis of the test antenna (53, 63) intersects with the axis which extends through the centre of symmetry of the antenna ($A_n$) to be stimulated in question and which is perpendicular to the radiating plane thereof.

4. The test device according to claim 3, **characterised in that** the antenna ($A_n$) to be stimulated being a horn with linear polarisation whose opening is arranged in a plane ($xOy$) and whose radiation axis is in alignment with an axis ($Oz$) perpendicular to the plane ($xOy$), the test antenna (63) is sized and arranged with respect to the antenna ($A_n$) to be stimulated in question so that:

   - the longitudinal axis thereof intersects with the axis ($Oz$);
   - the projection of the point P thereof on the plane ($xOy$) is at the edge of the zone which delimits the surface of the antenna ($A_n$) to be stimulated;
   - the projection of the point E thereof on the plane ($xOy$) is located inside the zone which delimits the surface of the antenna ($A_n$) to be stimulated;
   - the lengths $l_1$ and $l_2$ being substantially equal and their total corresponding to a fraction of the size of the antenna ($A_n$) to be stimulated in the direction of the longitudinal axis of the test antenna (63).

5. The test device according to claim 3, **characterised in that** the antenna ($A_n$) to be stimulated being a planar antenna with linear polarisation which is arranged in a plane *(xOy)* and whose centre of symmetry is in alignment with the point O, the test antenna (53) is sized and arranged with respect to the antenna ($A_n$) to be stimulated so that the longitudinal axis thereof intersects with the axis ($Oz$) perpendicular to the plane ($xOy$) at the point R; the lengths $l_1$ and $l_2$ being such that the total $l_1$ and $l_2$ thereof is at least equal to the dimension of the surface of the antenna ($A_n$) to be stimulated in the direction of the longitudinal axis of the test antenna (53).

6. The test device according to any one of claims 3 to 5, comprising a radome which protects the antenna to be stimulated in question, the test antenna (53, 63) is placed against the surface of the radome which protects the antenna ($A_n$) to be stimulated in question.

7. The test device for stimulating an antenna to be stimulated with bipolarisation having two orthogonal linear polarisations, **characterised in that** it comprises two test antennae (71-72, 81-82) according to either claim 1 or claim 2 and an antenna ($A_n$) to be stimulated and means for positioning the test antennae with respect to the antenna ($A_n$) to be stimulated in question so that:

   - each test antenna (71-72, 81-82) is placed in the near field of the antenna ($A_n$) to be stimulated in question;
   - the projection of the contour of each of the test antennae (71-72, 81-82) on the radiating plane of the antenna ($A_n$) to be stimulated is located inside the surface which delimits the antenna ($A_n$) to be stimulated in question;
   - the longitudinal axis of each of the test antennae (71-72, 81-82) is arranged parallel with the radiating plane of the antenna ($A_n$) to be stimulated and as close as possible thereto;
   - the longitudinal axes of the test antennae (71-72, 81-82) are aligned along perpendicular axes;
   - the longitudinal axis of each of the test antennae (71-72, 81-82) intersects with the axis which extends through the centre of symmetry of the antenna ($A_n$) to be stimulated and which is perpendicular to the plane which radiates therefrom;
   - the two test antennae (71-72, 81-82) are not in contact with each other.

8. The test device according to the preceding claim, **characterised in that** the antenna ($A_n$) to be stimulated being a bipolarisation horn having two orthogonal linear polarisations, whose opening is arranged in a plane (*xOy*) and whose axis of symmetry is in alignment with an axis (*Oz*) perpendicular to the plane (*xOy*), each of the test antennae (81, 82) is sized and arranged with respect to the antenna ($A_n$) to be stimulated in question so that:

   - the longitudinal axis thereof intersects with the axis (*Oz*);
   - the projection of the point *P* thereof on the plane (*xOy*) is at the edge of the zone which delimits the surface of the antenna ($A_n$) to be stimulated;
   - the projection of the point *E* thereof on the plane (*xOy*) is located inside the zone which delimits the surface of the antenna ($A_n$) to be stimulated;
   - the lengths $l_1$ and $l_2$ being substantially equal, their total corresponds to a fraction of the dimension of the antenna ($A_n$) to be stimulated in the direction of the longitudinal axis of the test antenna (81, 82) in question.

9. The test device according to claim 7, **characterised in that** the antenna ($A_n$) to be stimulated being a planar bipolarisation antenna which has two orthogonal linear polarisations and which is arranged in a plane (*xOy*) and whose centre of symmetry is in alignment with the point O, each of the test antennae (71, 72) is sized and arranged with respect to the aerial plane in such a manner that the longitudinal axis thereof intersects with the axis (*Oz*) perpendicular to the plane (*xOy*) at the point R; the lengths $l_1$ and $l_2$ being such that their total $l_1 + l_2$ is at least equal to the dimension of the surface of the antenna ($A_n$) to be stimulated in the direction of the longitudinal axis of the test antenna (71, 72) in question.

10. Test system for stimulating a plurality of antennae, **characterised in that** it comprises a plurality of test devices according to any one of claims 3 to 9, the devices being arranged so that each test device is placed opposite an antenna ($A_n$) to be stimulated from the plurality of antennae.

Fig. 1

24

23

$l_1$

$l_2$

$P_a$

$P$

21

$R$

$E$

22

Câble
Alimentation

Antenne de test $a_n$

# Fig. 2

43

31

24

$l_1$

$l_2$

$P$

48

$R$

42

$E$

Câble
Alimentation

Antenne de test $a_n$

# Fig. 3

Fig. 4

Fig. 5

Fig. 6

Fig. 7

Fig. 8

**RÉFÉRENCES CITÉES DANS LA DESCRIPTION**

**Documents brevets cités dans la description**

- FR 1700081
- US 2011077509 A1
- US 2002095304 A1
- US 6215448 B1
- JP 2009058384 A
- DE 102016001370 A1
- US 2007013607 A1